# EUROPEAN PATENT SPECIFICATION

(11) **EP 2 904 444 B1**
(45) Date of publication and mention of the grant of the patent: **02.03.2022**
(21) Application number: 13774139.3
(22) Date of filing: 07.10.2013
(51) Int. Cl.: G02B 26/08, G01D 5/241

(54) **METHOD AND COMPONENT FOR REGULATING THE TILTING OF A MIRROR ELEMENT**
VERFAHREN UND ANORDNUNG ZUM REGULIEREN DER VERKIPPUNG EINES SPIEGELELEMENTS
PROCÉDÉ ET DISPOSITIF DE RÉGLAGE DE LA INCLINAISON D'UN ÉLÉMENT MIROIR

(30) Priority: 05.10.2012 DE 102012218219; 05.10.2012 US 201261710058 P
(43) Date of publication of application: 12.08.2015
(73) Proprietor: Carl Zeiss SMT GmbH, 73447 Oberkochen (DE)
(72) Inventor: HORN, Jan, 80639 München (DE); BERGER, Lars, 73432 Aalen Unterkochen (DE); HARTMANN, Matthias, 73525 Schwäbisch Gmünd (DE); KNAUF, Benedikt, 73431 Aalen (DE); ORTH, Matthias, 73450 Neresheim-Elchingen (DE); WALDIS, Severin, CH-3012 Bern (CH)
(74) Representative: Rau, Schneck & Hübner Patentanwälte Rechtsanwälte PartGmbB
(86) International application number: PCT/EP2013/070813
(87) International publication number: WO 2014/053659

(56) References cited:
- US-A1- 2003 094 914
- US-A1- 2003 184 844
- US-A1- 2011 273 694
- US-B1- 6 464 363
- US-B1- 7 538 927

## Description

The invention relates to an optical component. The invention furthermore relates to a method for regulating the tilting of a mirror element. Finally, the invention relates to an illumination optical unit and an illumination system for a projection exposure apparatus and a projection exposure apparatus for microlithography, a method for producing a micro- or nanostructured component and a component produced according to the method.

Optical components having displaceable mirrors enable optical radiation to be guided very flexibly. An optical component having displaceable individual mirrors is known for example from WO 2010/049076 A2, WO 2013/120 927 A2, US 2011/0273694 A1, US 7 538 927 B1 and US 6 464 363 B1.

It is an object of the present invention to improve such an optical component.

This object is achieved by means of the features of Claim 1.

The heart of the invention consists in providing a signal generator for generating a modulation signal, said signal generator being connected in a signal-transmitting manner to an electrode mechanically connected to at least two actuator electrodes. Applying the modulation signal also to the mirror electrode is particularly advantageous. This requires a low constructional outlay and is independent of the application of actuator signals to the actuator electrodes for displacing the mirror elements.

The modulation signal has a frequency above a resonant frequency of the mirror element. It has, in particular, a lower limit frequency which lies at least one decade, in particular at least two decades, above the resonant frequency of the mirror element. Such frequencies are also designated hereinafter as high-frequency. This ensures that the modulation signal leads at most to a negligible mechanical excitation of the mirror element.

The mirror element is tiltable about at least one axis. It thus has at least one degree of freedom of tilting. It can also be tiltable about two tilting axes, in particular on two mutually perpendicular tilting axes. It has two degrees of freedom of tilting in this case. In a comparative example, at least one actuator electrode for tilting the mirror element is provided per degree of freedom of tilting. Designs in which the mirror elements are tiltable about two tilting axes by means of three actuator electrodes are also possible. In this case, the high-frequency modulation portion can preferably be applied to the mirror electrode. As an alternative thereto, the high-frequency modulation portion can be applied to all the actuator electrodes.

According to the invention, in each case two actuator electrodes are provided per degree of freedom of tilting. These are arranged in each case symmetrically with respect to a tilting axis. This further reduces the mechanical excitation of the mirror elements. In each case two actuator electrodes are connected to the signal generator in parallel for having the modulation signal applied to them in parallel.

The signal-to-noise ratio of a capacitive detection of disturbances of the tilting of the mirror element can be considerably improved by means of the high-frequency modulation signal. In this case, the invention makes use of the fact that the capacitive reactance decreases as the frequency increases. Disturbances of the tilting of the mirror element typically have frequencies which are at most of the order of magnitude of the resonant frequency of the mirror element. They therefore lead only to relatively small capacitive signals. By means of the high-frequency modulation, however, such disturbances can be detected in the form of an amplitude-modulated signal of relatively high amplitude.

The modulation signal has in particular a lower limit frequency of at least 100 Hz, in particular at least 300 Hz, in particular at least 1 kHz, in particular at least 2 kHz, in particular at least 5 kHz, in particular at least 10 kHz, in particular at least 30 kHz, and in particular at least 50 kHz. It can preferably be a sinusoidal signal. Such a signal can be generated in a particularly simple manner. Moreover, it allows particularly simple further processing of the detected sensor signal.

The signal generator can advantageously be integrated into a carrying structure of the optical component. It can in particular be designed as an electronic circuit or comprise such a circuit. The electronic circuit can be realized in particular by means of a so-called application specific integrated circuit (ASIC) in the carrying structure. This allows a very space-saving realization.

Moreover, the component can have at least one voltage source for applying a bias voltage to the at least one mirror electrode. This makes it possible to achieve higher forces and thus higher tilting angles with small voltage changes at the actuator electrodes. The electrical bias voltage is also designated as bias voltage (V_{Bias}) or bias for short.

In accordance with one advantageous embodiment, the at least two actuator electrodes simultaneously serves as the sensor electrodes of a sensor device of the local regulating device. The actuator electrodes thus form part of the sensor device. This simplifies, in particular, the constructional design of the optical component. It has been recognized according to the invention that the separation of the frequency ranges of the actuator system and of the sensor system allows such an advantageous embodiment.

Preferably, the sensor electrodes are connected in a signal-transmitting manner to a rectifier. This makes it possible to derive a feedback signal from the amplitude of the high-frequency signal detected by means of the sensor electrodes. The rectifier can be realized by a diode. This allows a constructional realization with a very small space requirement. Furthermore, it can be provided that the at least two actuator electrodes for having the modulation signal applied thereto are connected in a signal-transmitting manner to the high-frequency generator. This further simplifies the constructional design of the modulation device.

The optical component comprises a multiplicity of mirror elements. The latter are arranged in a matrix-like manner, i.e. as a so-called mirror array, in particular as a micro mirror array (MMA). The number of mirror elements of the optical component can be more than 1000, in particular more than 10 000, in particular more than 100 000.

In accordance with one aspect of the invention, the mirror electrodes of the mirror elements are designed in such a way that they are held at the same electrical potential. They are in particular electrically conductively connected to one another.

The mirror electrode can be in particular a part of the mirror body or the mirror body itself. The mirror electrode can also be designed as an actuator pin which is mechanically connected to the mirror body.

A further object of the invention consists in improving a method for regulating the tilting of a mirror element.

This object is achieved by means of the features of Claim 11. The heart of the invention consists in a voltage comprising at least one modulation portion being applied to at least two actuator electrodes mechanically connected to the carrying structure. A feedback signal for regulating the tilting of the mirror element is then determined from the amplitude and/or phase of the signal measured by means of a sensor device. Regulating the tilting should be understood here to mean regulating the position of the mirror element and/or regulating the tilting speed of the mirror element, in particular the damping thereof.

The modulation portion is preferably high-frequency, as described above. The modulation portion preferably has, in particular, a lower limit frequency which lies at least one decade, in particular at least two decades, above a resonant frequency of the mirror element. This ensures that the mirror element is mechanically excited at most to a negligible extent by the modulation signal. The excitation magnitude is in particular at most -20 decibels, in particular at most -30 decibels, in particular at most -40 decibels.

The advantages correspond to those described above for the optical component. In particular, the signal-to-noise ratio of the sensor signal can be improved by the modulation.

The feedback signal can be determined depending on a position signal, in particular depending on a detected tilting angle of the mirror element. It is likewise possible to determine the feedback signal depending on the time derivative of the tilting angle. In other words, the sensor device can be embodied as a position sensor or as a speed sensor.

Preferably, a bias voltage is additionally applied to the at least one mirror electrode. The bias voltage can be constant, in particular.

Preferably, the same bias voltage is applied to the mirror electrodes of a plurality of individual mirrors, in particular to the mirror electrodes of all the individual mirrors. In this case, the bias voltage can comprise in particular a modulation portion, i.e. an excitation voltage. By applying the same bias voltage to a multiplicity of the mirror electrodes, in particular to all the mirror electrodes, it is possible to considerably reduce the interconnection, in particular the complexity of the signal flow in the optical component.

An actuator voltage is additionally applied to the actuator electrodes for tilting the mirror element. The actuator voltage is controllable by means of a control device, in particular.

One advantageous embodiment provides for at least the actuator portion and the modulation portion to be applied to the actuator electrodes. The actuator voltage for displacing the mirror element by an actuator system and also the modulation portion for modulating the capacitively detected sensor signal are thus applied to said actuator electrodes, in particular simultaneously.

Moreover, the constant bias portion can also be applied to said actuator electrodes. In other words, a voltage signal composed of a superposition of a plurality of portions is applied to the actuator electrodes.

Further objects of the invention consist in improving an illumination optical unit and an illumination system for a projection exposure apparatus, and a projection exposure apparatus for microlithography. These objects are achieved by means of the features of Claims 8 to 10. The advantages correspond to those which have already been explained.

Further aspects of the invention consist in improving a method for producing a micro- or nanostructured component, and in improving a component produced in this way. These objects are achieved by means of the features of claim 14. The advantages likewise correspond to those which have already been explained.

Further details, advantages and particulars of the invention are evident from the description of a number of exemplary embodiments with reference to the drawings, in which:
- Figure 1: shows a schematic illustration of a projection exposure apparatus for microlithography in a meridional section,
- Figure 2: shows a schematic cross section through an excerpt from an optical component in accordance with a first embodiment,
- Figure 3: shows a schematic cross section through an excerpt from an optical component in accordance with a further embodiment,

- Figure 4: shows a schematic illustration of the optical component with a local and a global closed loop,
- Figure 5: shows a schematic illustration of an optical component in accordance with a further embodiment,
- Figure 6: shows a Bode diagram which represents by way of example the typical steady-state reaction of a mirror element to a harmonic excitation, and
- Figures 7 to 9: show schematic illustrations of further exemplary embodiments of the optical component,
- Figure 10 and Figure 11: show schematic views of an embodiment of a mirror array with cardanically suspended mirror elements, and
- Figure 12 and Figure 13: show schematic illustrations of an alternative embodiment of a mirror array having a multiplicity of individual mirrors.

Firstly, the basic construction of a projection exposure apparatus 1 is described below with reference to the figures.

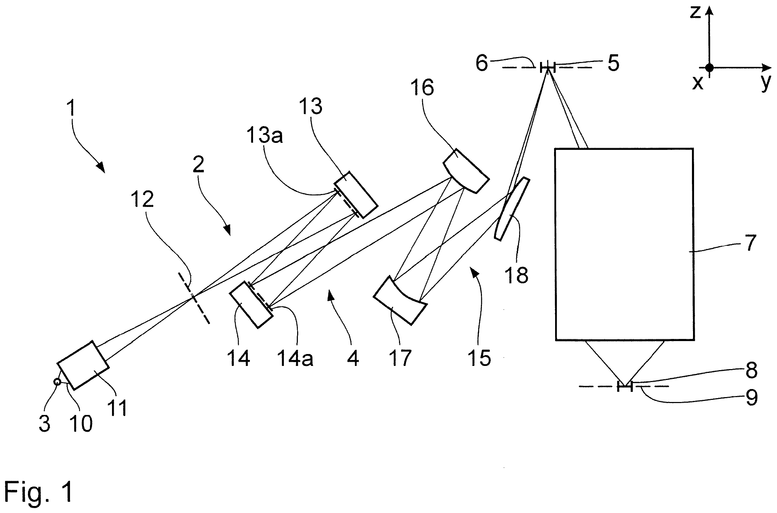

Figure 1 schematically shows a projection exposure apparatus 1 for microlithography in a meridional section. An illumination system 2 of the projection exposure apparatus 1 has, besides a radiation source 3, an illumination optical unit 4 for exposing an object field 5 in an object plane 6. The object field 5 can be configured as rectangular or arcuate with an x/y aspect ratio of 13/1, for example. A reflective reticle arranged in the object field 5 and not illustrated in Figure 1 is exposed in this case, said reticle bearing a structure to be projected by the projection exposure apparatus 1 for producing micro- or nanostructured semiconductor components. A projection optical unit 7 serves for imaging the object field 5 into an image field 8 in an image plane 9. The structure on the reticle is imaged onto a light-sensitive layer of a wafer arranged in the region of the image field 8 in the image plane 9, said wafer not being illustrated in the drawing.

The reticle, which is held by a reticle holder (not illustrated), and the wafer, which is held by a wafer holder (not illustrated), are scanned synchronously in the y-direction during the operation of the projection exposure apparatus 1. Depending on the imaging scale of the projection optical unit 7, it is also possible for the reticle to be scanned in the opposite direction relative to the wafer.

With the aid of the projection exposure apparatus 1, at least one part of the reticle is imaged onto a region of a light-sensitive layer on the wafer for lithographically producing a micro- or nanostructured component, in particular a semiconductor component, for example a microchip. Depending on the embodiment of the projection exposure apparatus 1 as a scanner or as a stepper, the reticle and the wafer are moved in a temporally synchronized manner in the y-direction continuously in scanner operation or step by step in stepper operation.

The radiation source 3 is an EUV radiation source having an emitted used radiation in the range of between 5 nm and 30 nm. A plasma source here, for example, a GDPP (gas discharge produced plasma) source, or an LPP (laser produced plasma) source can be involved in this case. Other EUV radiation sources, for example those based on a synchrotron or on a free electron laser (FEL), are also possible.

EUV radiation 10, which emerges from the radiation source 3 is focused by a collector 11. A corresponding collector is known from EP 1 225 481 A, for example. Downstream of the collector 11, the EUV radiation 10 propagates through an intermediate focal plane 12, before impinging on a field facet mirror 13 having a multiplicity of field facets 13a. The field facet mirror 13 is arranged in a plane of the illumination optical unit 4 that is optically conjugate with respect to the object plane 6.

The EUV radiation 10 is also designated hereinafter as used radiation, illumination light or as imaging light.

Downstream of the field facet mirror 13, the EUV radiation 10 is reflected by a pupil facet mirror 14 having a multiplicity of pupil facets 14a. The pupil facet mirror 14 lies either in the entrance pupil plane of the illumination optical unit 7 or in a plane that is optically conjugate with respect thereto. The field facet mirror 13 and the pupil facet mirror 14 are constructed from a multiplicity of individual mirrors 23, which are described in even greater detail below. In this case, the subdivision of the field facet mirrors 13 into individual mirrors 23 can be such that each of the field facets 13a, which per se illuminate the entire object field 5 is represented by exactly one of the individual mirrors 23. Alternatively, it is possible for at least some or all of the field facets 13a to be constructed by means of a plurality of such individual mirrors 23. The same correspondingly applies to the configuration of the pupil facets 14a of the pupil facet mirrors 14, which are respectively assigned to the field facets 13a and which can be formed in each case by a single individual mirror 23 or by a plurality of such individual mirrors 23.

The EUV radiation 10 impinges on the two facet mirrors 13, 14 at an angle of incidence, measured normal to the mirror surface, which is less than or equal to 25°. The EUV radiation 10 is therefore applied to the two facet mirrors 13, 14 in the range of normal incidence operation. Application with grazing incidence is also possible. The pupil facet mirror 14 is arranged in a plane of the illumination optical unit 4 that constitutes a pupil plane of the projection optical unit 7 or is optically conjugate with respect to a pupil plane of the projection optical unit 7. With the aid of the pupil facet mirror 14 and an imaging optical assembly in the form of a transfer optical unit 15 having mirrors 16, 17 and 18 designated in the order of the beam path for the EUV radiation 10, the field facets 13a of the field facet mirror 13 are imaged into the object field 5 in a mutually superimposing manner. The last mirror 18 of the transfer optical unit 15 is a mirror for grazing incidence ("grazing incidence mirror"). The transfer optical unit 15 together with the pupil facet mirror 14 is also designated as a sequential optical unit for transferring the EUV radiation 10 from the field facet mirror 13 toward the object field 5. The illumination light 10 is guided from the radiation source 3 toward the object field 5 via a plurality of illumination channels. Each of these illumination channels is assigned a field facet 13a of the field facet mirror 13 and a pupil facet 14a of the pupil facet mirror 14, said pupil facet being disposed downstream of said field facet. The individual mirrors 23 of the field facet mirror 13 and the pupil facet mirror 14 can be tiltable by an actuator system, such that a change in the assignment of the pupil facets 14a to the field facets 13a and correspondingly a changed configuration of the illumination channels can be achieved.

The mirror elements 23 of the illumination optical unit 4 are preferably arranged in an evacuateable chamber. They are mechanically undamped to the greatest possible extent, such that they react very sensitively to disturbances as a result of vibrations.

The construction of the field facet mirror 13, in particular of the individual mirrors 23 thereof, is described in greater detail below. However, the invention is not restricted thereto. Generally, the individual mirrors 23 are parts of an optical component 25.

The individual mirrors 23 are also designated hereinafter as mirror elements 23. They are designed to be tiltable by an actuator system, as will be explained below. Overall, the field facet mirror 13 has at least 300, in particular at least 1000, in particular at least 10 000, in particular at least 100 000, individual mirrors 23.

The mirror elements 23 can be, in particular so-called micro mirrors. They have in particular dimensions in the range of 10⁻⁸ m² to 10⁻⁴ m², in particular in the range of 10⁻⁷ m² to 10⁻⁵ m². In principle, macroscopic mirrors having larger dimensions can also be involved.

The mirror elements 23 are arranged on a first carrying structure 19. The latter is mechanically connected to a mirror body 20 of one of the mirror elements 23 via a heat-conducting section. Part of the heat-conducting section is an articulated body 21, that permits the mirror body 20 to be tilted relative to the first carrying structure 19. The articulated body 21 can be designed as flexure that permits the mirror body 20 to be tilted about defined tilting axes, for example about one or two tilting axes, in particular arranged perpendicular to one another. For details of the tiltable arrangement of the mirror elements 23, in particular the arrangement thereof in the first carrying structure 19, reference should be made to DE 10 2011 006 100 A1 and WO 2013/120 926 A1.

The mirror element 23 is in each case mechanically connected to an actuator pin 22. The actuator pin 22 forms an electrode which is mechanically connected to the mirror, and which is also designated hereinafter as mirror electrode.

The first carrying structure 19 forms in each case a sleeve surrounding the actuator pin 22. Actuator electrodes 24 are in each case integrated in the sleeve. In each case two actuator electrodes 24 are provided per degree of freedom of tilting. As a comparative example, it is also possible to provide three actuator electrodes 24 for tilting the mirror element 23 with two degrees of freedom of tilting. The three actuator electrodes 24 are preferably arranged in a manner offset in each case by 120° relative to one another in the circumferential direction. An arrangement that deviates from this is likewise possible.

By generating a potential difference between one or more of the actuator electrodes 24 and the actuator pin 22, it is possible to generate an electrostatic force on the actuator pin 22 which can lead to a tilting of the mirror element 23. Generally, an actuator voltage V_{Act} is applied to the actuator electrodes 24 for tilting the mirror element 23.

On account of the degrees of freedom of tilting of the mirror elements 23, undesired oscillations thereof can occur. The mirror elements 23 have a mechanical behavior which can be described by a so-called PT2 behavior.

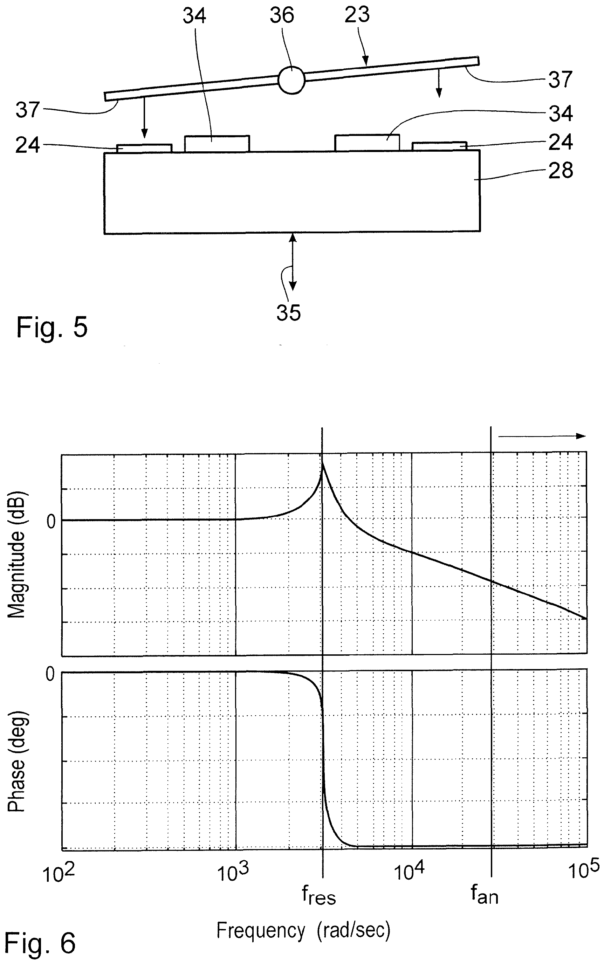

A typical amplitude and phase response of such a system is illustrated in Figure 6. The system has a resonant frequency fᵣₑₛ. Above the latter, the gain of the mechanical system decreases monotonically. At an excitation frequency fₐₙ, lying one decade above the resonant frequency fᵣₑₛ, fₐₙ = 10 fᵣₑₛ, the amplitude has already fallen, that is to say been damped by 40 decibels. At even higher frequencies, the mechanical excitation of the mirror element 23 is thus negligible.

The mirror elements 23 are arranged in a matrix-like manner in a so-called mirror array. For further details in this regard, reference should once again be made to DE 10 2011 006 100 A1 and WO 2013/120 926 A1.

The optical component 25 comprises a second carrying structure 26 besides the mirror elements 23 arranged in the first carrying structure 19. The second carrying structure 26 is arranged in a manner offset with respect to the mirror elements 23. It has, in particular, a cross section identical to that of the first carrying structure 19. The second carrying structure 26 serves for arranging and/or taking up further functional parts, in particular a control device 27 for controlling the displacement of the mirror elements 23. The control device 27 comprises, in particular, an application specific integrated circuit 28 (ASIC). The control device 27 can also be integrated into the ASIC 28.

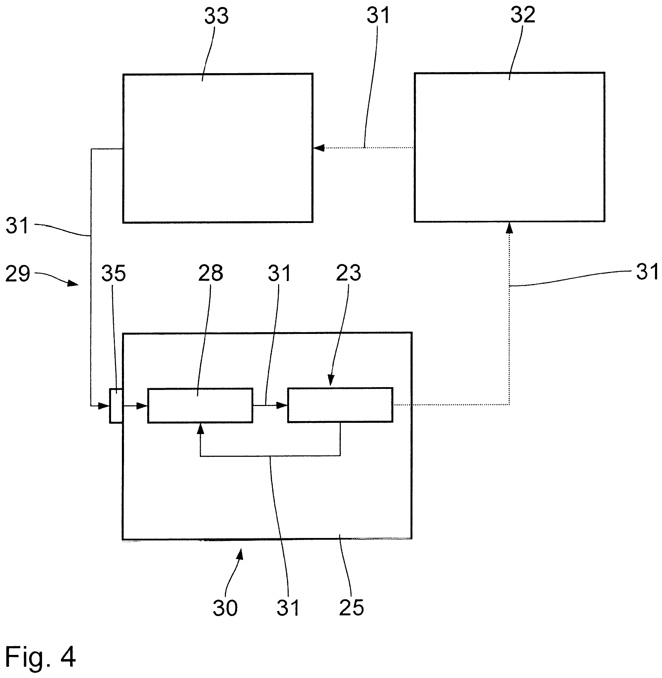

As illustrated schematically in Figure 4, the invention provides two regulating devices 29, 30 for positioning the mirror elements 23. In this case, the regulating device 29 is a global closed loop for predefining absolute position data for the positioning of each of the mirror elements 23, while a local closed loop for suppressing momentary disturbances of the positioning of the mirror elements 23, in particular for damping oscillations around the resonant frequency of the mirror elements 23, serves as the regulating device 30. The local closed loop 30 is integrated in particular into the optical component 25. A signal flow 31 in the regulating devices 29, 30 is illustrated by arrows in Figure 4. The ASIC 28 with the local regulating device 30 can be connected to the global regulating device 29 via an interface 35.

The global regulating device 29 comprises a global sensor device 32 for monitoring the absolute positioning of the mirror elements 23. The global sensor device 32 can have a camera system for phase measuring deflectometry. For details of said system, reference should be made to WO 2010/094658 A1.

The global regulating device 29 additionally comprises a global control device 33 for predefining absolute positions of the mirror elements 23. The global control device 33 serves in particular for predefining actuator voltages or other manipulated variables.

The local regulating device 30 comprises a sensor device 38 having at least one, preferably at least two sensor electrodes 34. The sensor electrodes 34 can be arranged on the ASIC 28. In particular, in each case at least two sensor electrodes 34 are provided per degree of freedom of tilting. The sensor electrodes 34 can be interconnected differentially, in particular. A different number of sensor electrodes 34 is likewise possible. Advantageously, a corresponding sensor electrode 34 is provided for each actuator electrode 24. The sensor electrodes 34 are part of a capacitive sensor.

Generally, the sensor device 38 comprises a means, in particular a circuit, for detecting a capacitance change. The sensor device 38 comprises, in particular, one or a plurality of electronic circuits for evaluating the signals from the sensor electrodes 34. Such circuits are preferably integrated into the ASIC 28. The sensor device 38 is connected in a signal-transmitting manner to the control device 27.

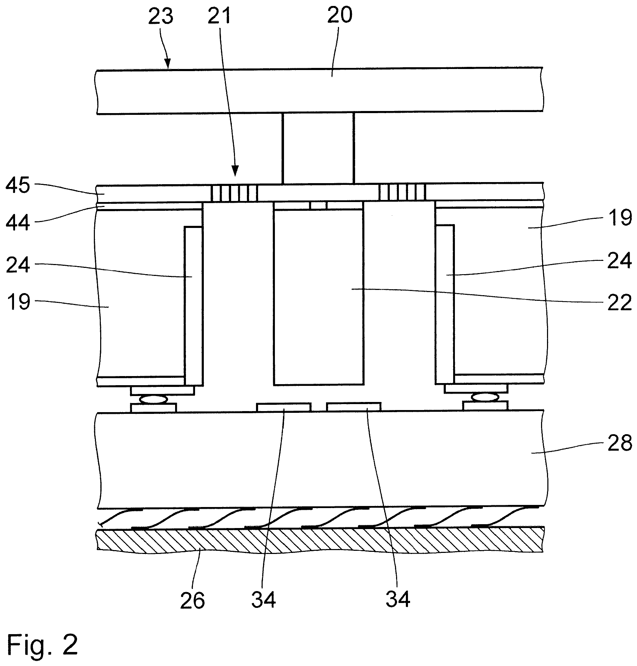

The sensor electrodes 34 can be integrated into the ASIC 28, in particular. This is provided in particular in the case of an embodiment in accordance with Figure 2, in which the mirror electrode is embodied as an actuator pin 22.

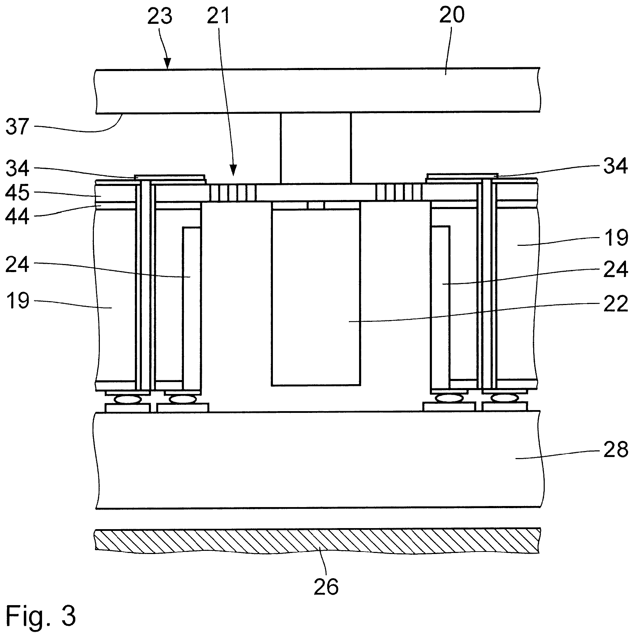

In the case of the exemplary embodiment illustrated in Figure 3, the mirror electrode 37 is formed by the mirror body 20 itself. The latter thus forms the movable electrode of the local sensor device 38. In this case, the rigid sensor electrodes 34 are arranged on that side of the first carrying structure 19 which faces the mirror element 23. They are thus arranged directly below the mirror body 20 of the mirror element 23.

In the case of the embodiment illustrated schematically in Figure 5 the actuator electrodes 24 are also arranged on that side of the first carrying structure 19 which faces the mirror element 23. The actuator pin 22 can be omitted in this exemplary embodiment. The mirror element 23 can be mounted in a tiltable manner by means of a spring element, in particular by means of a torsion spring 36. The mirror element 23 can also be mounted by means of a cardanic suspension.

The functioning of the local regulation is described in greater detail below. As already described, the mirror element 23 can be tilted by a voltage being applied between the actuator electrodes 24 and the mirror electrode 37. Conversely, the capacitance between the sensor electrode 34 and the mirror electrode 37 changes when the mirror element 23 is tilted. Such capacitance changes can be detected by means of the sensor electrodes 34. A feedback signal for regulating the tilting of the mirror element 23 can then be determined from the amplitude of the measured signal.

The invention provides for applying a constant bias voltage V_{Bias} to the mirror element 23. What can thereby be achieved is that higher forces and thus higher tilting angles of the mirror elements 23 are produced with smaller voltage changes at the actuator electrodes 24. The bias voltage V_{Bias} is applied in particular in each case to the mirror electrode 37. The latter can be formed by the actuator pin 22 or by the mirror body 20. In principle, it is also possible to apply the bias voltage V_{Bias} to the actuator electrodes 24.

In order to generate a constant bias voltage V_{Bias}, the optical component 25 can comprise a voltage source 40.

Furthermore, provision is made for applying a high-frequency excitation voltage V_{Mod} to the mirror element 23, in particular the mirror electrode 37. For this purpose, the optical component 25 comprises a signal generator 39. The signal generator 39 is a high-frequency generator, in particular. In this case, high-frequency should once again be understood to mean frequencies above the resonant frequency of the mirror elements 23, in particular frequencies which lie at least one decade, in particular at least two decades above the resonant frequency of the mirror elements 23. The signal generator 39 is integrated in particular as an electronic circuit into the ASIC 28.

The excitation voltage V_{Mod} has, in particular, a frequency which lies at least one decade above the resonant frequency of the mirror element 23. The excitation voltage V_{Mod} can be a sinusoidal AC voltage, in particular. It can have a frequency of at least 100 Hz, in particular at least 300 Hz, in particular at least 1 kHz, in particular at least 2 kHz, in particular at least 5 kHz, in particular at least 10 kHz, in particular at least 20 kHz, in particular at least 50 kHz, in particular at least 100 kHz. Generally, the excitation voltage V_{Mod} has a lower limit frequency which lies at least one decade above the resonant frequency fᵣₑₛ of the mirror element 23. An excitation of the mirror element 23 with such high frequencies leads at most to a negligible mechanical excitation of the mirror element 23. However, higher capacitive currents can be generated with higher frequencies since the capacitive impedance falls as the frequency increases. This leads to an improved signal-to-noise ratio.

The excitation voltage V_{Mod} can also have a form which deviates from this. It can in particular be formed from a superposition of two or more sinusoidal AC voltages having different frequencies. A rectangular or triangular AC voltage can also be involved.

Generally, the excitation voltage V_{Mod} involves a modulation of the bias voltage V_{Bias} and/or the actuator voltage V_{Act} of the mirror element 23. In other words, the excitation voltage V_{Mod} forms a modulation portion of the bias voltage V_{Bias} and/or of the actuator voltage V_{Act}. The excitation voltage V_{Mod} is also designated as modulation signal.

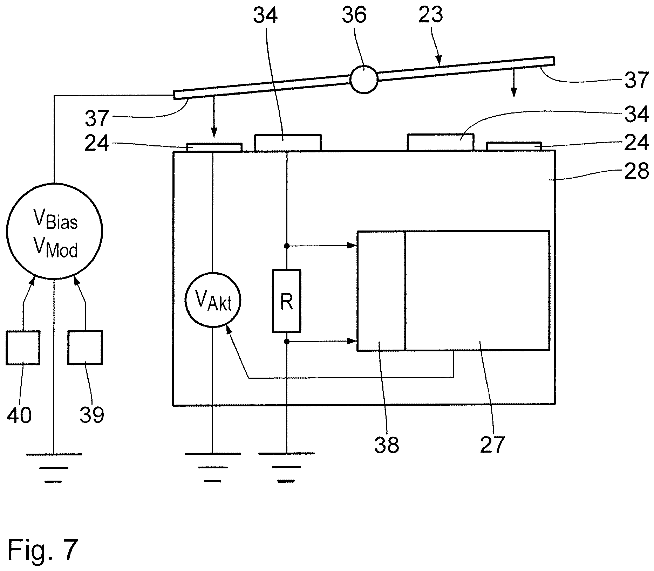

As an exemplary realization for the evaluation of the capacitance change, Figures 7 to 9 in each case illustrated the evaluation with an RC element. Here the voltage drop across the resistor R is dependent on the capacitance between the sensor electrode 34 and the mirror 23, that is to say the mirror electrode 37. Since resistors usually require a large amount of ASIC chip area, a voltage divider consisting only of capacitors can also be used. Alternatively, a current measurement can also be effected directly by the capacitor, for example by a current/voltage amplifier.

In order to determine a feedback signal, the signal measured by means of the sensor device 38 is rectified. In particular, a rectifier in the form of a diode is provided for this purpose. This allows a realization with a small chip area requirement.

Alternative possibilities for measuring the capacitance changes are conceivable. By way of example, it is also possible to measure voltage drops if the sensor electrodes 34 are interconnected for example in each case in an RC element. A phase measurement of the sinusoidal voltage drop at an RC element is also conceivable.

For regulating the tilting of the mirror element 23, the feedback signal is applied to the actuator electrodes 24 by means of the control device 27. The feedback signal can also be fed to a plurality of actuator electrodes 24.

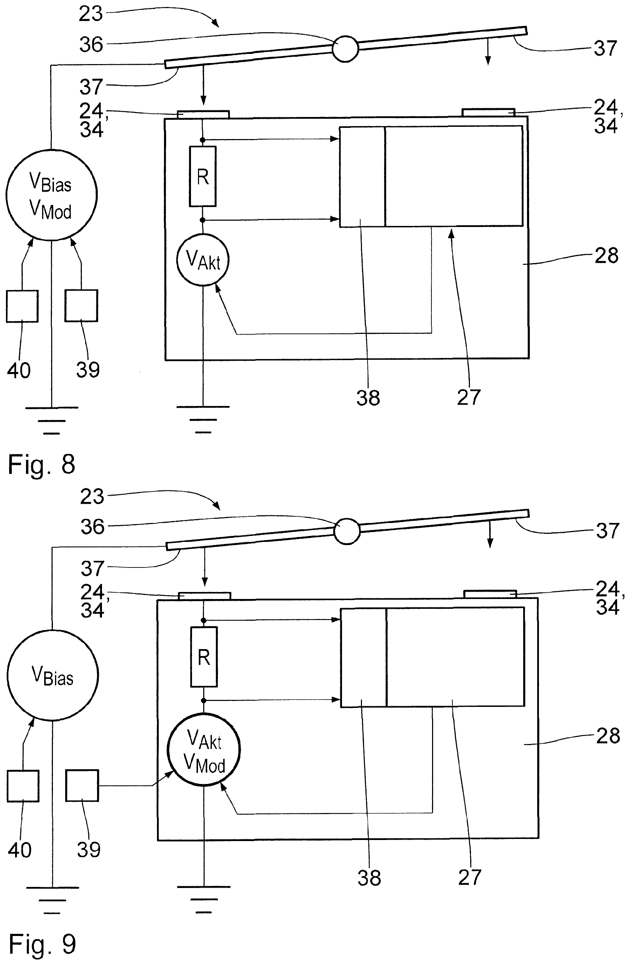

In one advantageous embodiment, illustrated in Figure 8, the actuator electrodes 24 simultaneously serve as sensor electrodes 34. Constructionally separate sensor electrodes can be dispensed with in this case. Here, use is made of the fact that the frequency ranges of the actuator system and of the sensor system are separate.

In accordance with a further embodiment, illustrated in Figure 9, provision is made for applying the high-frequency excitation voltage V_{Mod} to the actuator electrodes 24. In principle, it is also conceivable for the constant bias voltage V_{Bias} also to be applied to the actuator electrodes 24. In this case, in addition to the actuator portion, the modulation portion and also, if appropriate, the bias voltage portion are applied to the actuator electrodes 24. The excitation signal has to be introduced into all the driving channels in this case.

A description has been given above of the regulation of the tilting of the mirror element 23 only with respect to one tilting axis. It goes without saying that the same principles can be applied to other designs, for example with three actuator electrodes 24 and two tilting axes.

A low-frequency disturbance of the positioning of the mirror elements 23 can also be regulated with the aid of the global positioning system 29. A low-frequency disturbance should be understood to mean for example a disturbance having a frequency which lies at least one decade below the resonant frequency of the mirror element 23.

The regulation according to the invention of the tilting of the mirror elements 23 is advantageous particularly for optical components 25 having a large number of individual mirrors 23. However, it can correspondingly also be applied to macroscopic individual mirrors 23.

As has been explained above, the excitation voltage V_{Mod} can be part of the bias voltage V_{Bias} of the mirror elements 23. The excitation voltage V_{Mod} can thus be applied directly to the mirror elements 23, in particular to all the mirror elements 23, of the optical component 25. In this case, only a single electrical contact is necessary for applying the excitation voltage V_{Mod} and the bias voltage V_{Bias} to the optical component 25, in particular to all the individual mirrors 23 thereof. As a result, a large amount of area on the ASIC 28 can be saved. As a result, space can in turn be provided on the ASIC 28 for further functions.

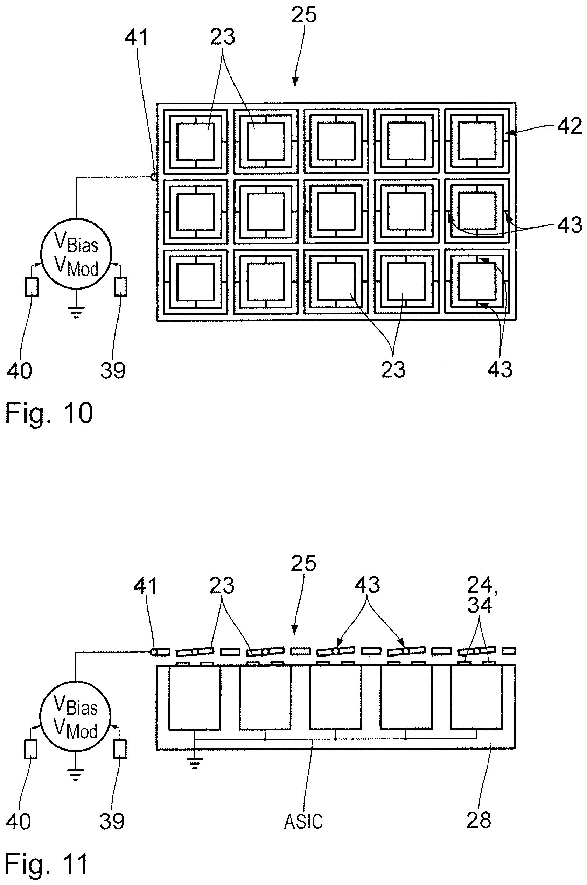

One possible embodiment is illustrated schematically in Figs. 10 and 11. In this embodiment illustrated by way of example, the individual mirrors 23 are mounted such that they are pivotable in each case about two axes, in particular about two axes running perpendicular to one another. The individual mirrors 23 are mounted in particular by means of a cardanic suspension 42. The cardanic suspension 42 comprises articulated joints 43 in each case for each pivoting axis. The articulated joints 43 can be of resilient design.

Advantageously, the individual mirrors 23 and the cardanic suspensions 42, in particular the articulated joints 23, are produced from a single wafer. By doping this wafer, i.e. by using a conductive wafer or producing a corresponding conductivity, what can be achieved in a simple manner is that all the individual mirrors 23 share the same electrical potential, i.e. exhibit an isopotential nature. A common bias voltage V_{Bias} and/or excitation voltage V_{Mod} can be applied to them in particular in a simple manner.

In this exemplary embodiment, the mirror bodies of the mirror elements 23 in each case form both the optically active part and the counter electrodes for actuating the individual mirror 23.

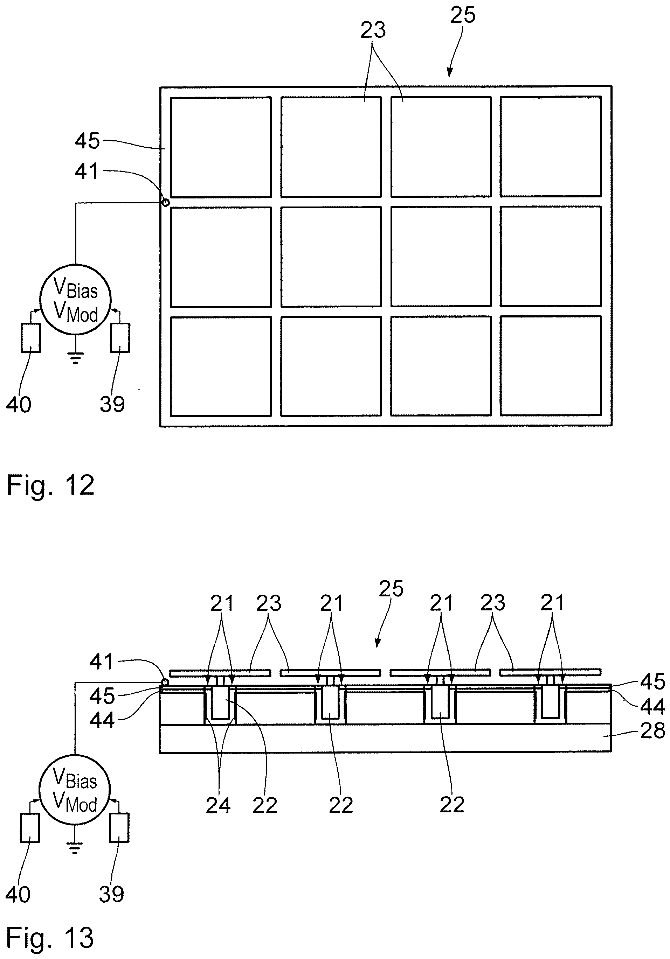

Figs. 12 and 13 schematically illustrate an alternative embodiment of the optical component 25. In this embodiment, the individual mirrors 23 are mounted such that they are pivotable in each case by means of an articulated body 21. For details, reference should be made to the description above. In the case of such mounting, too, it is possible to apply the same bias voltage V_{Bias} to all the mirror elements 23 of the optical component 25 or the actuator pins 22 thereof. The exemplary embodiment in accordance with Figs. 12 and 13 has a high filling factor, in particular, i.e. a high proportion of the total cross-sectional area of the optical component 25 is constituted by the active optical surface, in particular the reflection surface of the totality of the individual mirrors 23. The filling factor can be in particular at least 0.7, in particular at least 0.8, in particular at least 0.9.

As already illustrated in Figs. 2 and 3, the articulated body 21 is insulated from the first carrying structure 19, in particular from the actuator electrodes 24, by an insulation layer 44. The articulated body 21 is part of an electrically conductive connecting layer 45. Via the connecting layer 45, the same bias voltage V_{Bias} and the same excitation voltage V_{Mod} can be applied to the actuator pins 22 of all the mirror elements 23 of the optical component 25.

In this embodiment, the electrical potential of the individual mirrors 23, i.e. the mirror bodies thereof, is not directly relevant to the actuation, sensing and regulation of their displacement.

The individual mirrors 23 are displaced by means of the actuator pin 22, which serves as a counterelectrode for all the actuator electrodes 24 and sensor electrodes 34. In this case, the actuator electrodes 24 can once again serve as sensor electrodes 34, as described above.

The embodiments illustrated in Figs. 10 to 13 can also be modified. By way of example, it is possible to apply an identical bias voltage V_{Bias} only to subgroups of the individual mirrors 23 of an optical component 25. In this case, the bias voltage V_{Bias} can differ between different subgroups. A corresponding grouping of the individual mirrors can be achieved in a simple manner by means of a suitable patterning of the wafer during their production. Moreover, the embodiments can be modified in a simple manner for implementing the realizations in accordance with Figs. 7 to 9.

During the use of the projection exposure apparatus 1 a reticle and the wafer are provided, said wafer bearing a coating that is light-sensitive to the illumination light 10. Afterward, at least one section of the reticle is projected onto the wafer with the aid of the projection exposure apparatus 1. During the projection of the reticle onto the wafer, the reticle holder and/or the wafer holder can be displaced in a direction parallel to the object plane 6 and/or parallel to the image plane 9. The reticle and the wafer can preferably be displaced synchronously with one another. Finally, the light-sensitive layer on the wafer that has been exposed with the illumination light 10 is developed. A micro- or nanostructured component, in particular a semiconductor chip is produced in this way.

## Claims

1. Optical component (25) comprising
a. a carrying structure (19),
b. a multiplicity of mirror elements (23) arranged in a matrix-like manner, each mirror element (23) being mounted such that it is tiltable relative to the carrying structure (19) by an actuator system, wherein each mirror element (23) comprises at least one mirror electrode (22; 37),
c. at least one local regulating device (30) per mirror element (23) for regulating the tilting of the mirror element (23), said local regulating device (30) having
i. a sensor device (38) having at least one capacitive sensor and
ii. an actuator device for tilting the mirror element (23), said actuator device having at least two actuator electrodes (24) per degree of freedom of tilting,
d. said optical component (25) further comprising a signal generator (39) for generating a modulation signal having a frequency above a resonant frequency of the mirror element (23),
e. wherein the signal generator (39) is connected in a signal-transmitting manner to the actuator electrodes (24),
f. wherein the at least two actuator electrodes (24) of each mirror element (23) arranged symmetrically with respect to a tilting axis of the mirror element (23) and are connected to the signal generator (39) in parallel for having the modulation signal applied to them in parallel.

2. Optical component (25) according to claim 1, **characterized in that** the actuator electrodes (24) are arranged on a side of the carrying structure (19) which faces the mirror element (23).

3. Optical component (25) according of any of the preceding claims, **characterized by** sensor electrodes (34) arranged below a mirror body (20) of the mirror element (23).

4. Optical component (25) according to any of the preceding claims, **characterized by** at least one voltage source (40) for applying a bias voltage (V_{Bias}) to the at least one mirror electrode (23).

5. Optical component (25) according to any of the claims 3 or 4, **characterized in that** the at least two actuator electrodes (24) simultaneously serve as the sensor electrodes (34) of the sensor device (38) of the local regulating device (30).

6. Optical component (25) according to claim 5, **characterized in that** the at least one sensor electrode (34) is connected in a signal-transmitting manner to a rectifier.

7. Optical component (25) according to claim 6, **characterized in that** all the mirror elements (23) in each case comprise a mirror electrode (22; 37) which is held in an isopotential manner with respect to the mirror electrodes (22; 37) of the other mirror elements (23).

8. Illumination optical unit (4) comprising a first facet mirror (13) having at least one optical component (25) according to any of claims 1 to 7.

9. Illumination system (2) comprising
a. an illumination optical unit (4) according to claim 8 and
b. a radiation source (3).

10. Projection exposure apparatus (1) for microlithography comprising
a. an illumination optical unit (4) according to claim 9 and
b. a projection optical unit (7).

11. Method for regulating the tilting of a mirror element (23) of an optical component (25) as defined by claim 1, wherein the optical component (25) is a facet mirror (13, 14) comprising the following steps:
a. providing a facet mirror (13, 14) with a multiplicity of mirror elements (23) with the individual mirror elements (23) being tiltable by an actuator system and having at least one mirror electrode (22; 37), which forms part of a capacitive sensor,
b. providing at least one actuator device having at least two actuator electrodes (24) per degree of freedom of tilting for tilting the mirror element (23) arranged in each case symmetrically with respect to a tilting axis,
c. providing a signal generator (39) for generating a modulation signal having a frequency above a resonant frequency of the mirror element (23), wherein the signal generator (39) is connected in a signal-transmitting manner to the actuator electrodes (24),
d. applying a voltage comprising at least one modulation portion (V_{Mod}) to the at least two actuator electrodes (24), wherein the modulation portion (V_{Mod}) is applied to two actuator electrodes (24) in parallel,
e. detecting a sensor signal by means of the capacitive sensor, and
f. determining a feedback signal for regulating the tilting of the mirror element (23) from the amplitude and/or phase of the sensor signal.

12. Method according to claim 11, **characterized in that** the modulation portion (V_{Mod}) has a lower limit frequency which lies at least one decade above a resonant frequency (fᵣₑₛ) of the mirror element (23).

13. Method according to either of claims 11 and 12, **characterized in that** at least an actuator portion (V_{Act}) and the modulation portion (V_{Mod}) are applied to the at least two actuator electrodes (24).

14. Method for producing a micro- or nanostructured component comprising the following steps:
- providing a substrate, to which a layer composed of a light-sensitive material is at least partly applied,
- providing a reticle having structures to be imaged,
- providing a projection exposure apparatus (1) according to claim 10,
- projecting at least one part of the reticle onto a region of the light-sensitive layer of the substrate with the aid of the projection exposure apparatus (1).

## Patentansprüche

1. Optische Komponente (25), die Folgendes umfasst:
a. eine Trägerstruktur (19),
b. eine Mehrzahl von Spiegelelementen (23), die matrixartig angeordnet sind, wobei jedes Spiegelelement (23) derart montiert ist, dass es relativ zu der Trägerstruktur (19) durch ein Aktorsystem geneigt werden kann, wobei jedes Spiegelelement (23) mindestens eine Spiegelelektrode (22; 37) umfasst,
c. mindestens eine lokale Reguliervorrichtung (30) pro Spiegelelement (23) zum Regulieren der Neigung des Spiegelelements (23), wobei die lokale Reguliervorrichtung (30) Folgendes aufweist:
i. eine Sensorvorrichtung (38), die mindestens einen kapazitiven Sensor aufweist, und
ii. eine Aktorvorrichtung zum Neigen des Spiegelelements (23), wobei die Aktorvorrichtung mindestens zwei Aktorelektroden (24) pro Neigungsfreiheitsgrad aufweist,
d. wobei die optische Komponente (25) ferner einen Signalgenerator (39) zum Erzeugen eines Modulationssignals umfasst, das eine Frequenz oberhalb einer Resonanzfrequenz des Spiegelelements (23) aufweist,
e. wobei der Signalgenerator (39) mit den Aktorelektroden (24) signalübertragend verbunden ist,
f. wobei die mindestens zwei Aktorelektroden (24) jedes Spiegelelements (23) bezüglich einer Neigungsachse des Spiegelelements (23) symmetrisch angeordnet sind und mit dem Signalgenerator (39) parallel verbunden sind, damit das Modulationssignal parallel an sie angelegt werden kann.

2. Optische Komponente (25) nach Anspruch 1, **dadurch gekennzeichnet, dass** die Aktorelektroden (24) auf einer Seite der Trägerstruktur (19), die dem Spiegelelement (23) zugewandt ist, angeordnet sind.

3. Optische Komponente (25) nach einem der vorhergehenden Ansprüche, **gekennzeichnet durch** Sensorelektroden (34), die unterhalb eines Spiegelkörpers (20) des Spiegelelements (23) angeordnet sind.

4. Optische Komponente (25) nach einem der vorhergehenden Ansprüche, **gekennzeichnet durch** mindestens eine Spannungsquelle (40) zum Anlegen einer Vorspannung (V_{Bias}) an mindestens eine Spiegelelektrode (23) .

5. Optische Komponente (25) nach einem der Ansprüche 3 oder 4, **dadurch gekennzeichnet, dass** die mindestens zwei Aktorelektroden (25) gleichzeitig als die Sensorelektroden (34) der Sensorvorrichtung (38) der lokalen Reguliervorrichtung (30) dienen.

6. Optische Komponente (25) nach Anspruch 5, **dadurch gekennzeichnet, dass** die mindestens eine Sensorelektrode (34) mit einem Gleichrichter signalübertragend verbunden ist.

7. Optische Komponente (25) nach Anspruch 6, **dadurch gekennzeichnet, dass** alle Spiegelelemente (23) in jedem Fall eine Spiegelelektrode (22; 37) umfassen, die bezüglich der Spiegelelektroden (22; 37) der anderen Spiegelelemente (23) auf einem Isopotential gehalten wird.

8. Optische Beleuchtungseinheit (4), die einen ersten Facettenspiegel (13) umfasst, der mindestens eine optische Komponente (25) nach einem der Ansprüche 1 bis 7 aufweist.

9. Beleuchtungssystem (2), das Folgendes umfasst:
a. eine optische Beleuchtungseinheit (4) nach Anspruch 8, und
b. eine Strahlungsquelle (3).

10. Projektionsbelichtungsanlage (1) für Mikrolithographie, die Folgendes umfasst:
a. eine optische Beleuchtungseinheit (4) nach Anspruch 9, und
b. eine optische Projektionseinheit (7).

11. Verfahren zum Regulieren der Neigung eines Spiegelelements (23) einer optischen Komponente (25) nach Anspruch 1, wobei die optische Komponente (25) ein Facettenspiegel (13, 14) ist, wobei das Verfahren die folgenden Schritte umfasst:
a. Bereitstellen eines Facettenspiegels (13, 14) mit einer Mehrzahl von Spiegelelementen (23), wobei die einzelnen Spiegelelemente (23) durch ein Aktorsystem geneigt werden können und mindestens eine Spiegelelektrode (22; 37) aufweisen, die einen Teil eines kapazitiven Sensors bildet,
b. Bereitstellen mindestens einer Aktorvorrichtung, die mindestens zwei Aktorelektroden (24) pro Neigungsfreiheitsgrad aufweist, um das Spiegelelement (23), das in jedem Fall bezüglich einer Neigungsachse symmetrisch angeordnet ist, zu neigen,
c. Bereitstelllen eines Signalgenerators (39) zum Erzeugen eines Modulationssignals, das eine Frequenz aufweist, die oberhalb einer Resonanzfrequenz des Spiegelelements (23) liegt, wobei der Spiegelgenerator (39) mit den Aktorelektroden (24) signalübertragungstechnisch verbunden ist,
d. Anlegen einer Spannung, die mindestens einen Modulationsabschnitt (V_{Mod}) aufweist, an die mindestens zwei Aktorelektroden (24), wobei der Modulationsabschnitt (V_{Mod}) an zwei Aktorelektroden (24) parallel angelegt wird,
e. Detektieren eines Sensorsignals mittels des kapazitiven Sensors, und
f. Bestimmen eines Rückkopplungssignals zum Regulieren der Neigung des Spiegelelements (23) aus der Amplitude und/oder der Phase des Sensorsignals.

12. Verfahren nach Anspruch 11, **dadurch gekennzeichnet, dass** der Modulationsabschnitt (V_{Mod}) eine untere Grenzfrequenz, die mindestens eine Dekade oberhalb einer Resonanzfrequenz (fᵣₑₛ) des Spiegelelements (23) liegt, aufweist.

13. Verfahren nach einem der Ansprüche 11 oder 12, **dadurch gekennzeichnet, dass** zumindest ein Aktorabschnitt (V_{Act}) und der Modulationsabschnitt (V_{Mod}) an die mindestens zwei Aktorelektroden (24) angelegt werden.

14. Verfahren zum Herstellen einer mikro- oder nanostrukturierten Komponente, das die folgenden Schritte umfasst:
- Bereitstellen eines Substrats, auf das zumindest teilweise eine Schicht, die aus einem lichtempfindlichen Material zusammengesetzt ist, aufgebracht ist,
- Bereitstellen einer Maske, die abzubildende Strukturen aufweist,
- Bereitstellen einer Projektionsbelichtungsanlage (1) nach Anspruch 10,
- Projizieren mindestens eines Teils der Maske auf einen Bereich der lichtempfindlichen Schicht des Substrats mit Hilfe der Projektionsbelichtungsanlage (1).

## Revendications

1. Composant optique (25), comprenant
a. une structure porteuse (19),
b. une pluralité d'éléments de miroir (23) agencés à la manière d'une matrice, chaque élément de miroir (23) étant monté de sorte à être inclinable par rapport à la structure porteuse (19) par un système actionneur, chaque élément de miroir (23) comprenant au moins une électrode de miroir (22 ; 37),
c. au moins un dispositif régulateur local (30) pour chaque élément de miroir (23) destiné à réguler l'inclinaison de l'élément de miroir (23), ledit dispositif régulateur local (30) possédant
i. un dispositif capteur (38) possédant au moins un capteur capacitif, et
ii. un dispositif actionneur destiné à incliner l'élément de miroir (23), ledit dispositif actionneur possédant au moins deux électrodes d'actionneur (24) pour chaque degré de liberté d'inclinaison,
d. ledit composant optique (25) comprenant en outre un générateur de signaux (39) destiné à générer un signal de modulation possédant une fréquence au-dessus d'une fréquence de résonance de l'élément de miroir (23),
e. le générateur de signaux (39) étant relié aux électrodes d'actionneur (24) pour permettre la transmission de signaux,
f. les au moins deux électrodes d'actionneur (24) de chaque élément de miroir (23) étant agencées symétriquement par rapport à un axe d'inclinaison de l'élément de miroir (23) et étant reliées en parallèle au générateur de signaux (39) pour que le signal de modulation leur soit appliqué en parallèle.

2. Composant optique (25) selon la revendication 1, **caractérisé en ce que** les électrodes d'actionneur (24) sont agencées d'un côté de la structure porteuse (19) qui est en regard de l'élément de miroir (23).

3. Composant optique (25) selon l'une quelconque des revendications précédentes, **caractérisé par** des électrodes de capteur (34) agencées en dessous d'un corps de miroir (20) de l'élément de miroir (23).

4. Composant optique (25) selon l'une quelconque des revendications précédentes, **caractérisé par** au moins une source de tension (40) destinée à appliquer une tension de polarisation (V_{Bias}) à l'au moins une électrode de miroir (23).

5. Composant optique (25) selon l'une quelconque des revendications 3 ou 4, **caractérisé en ce que** les au moins deux électrodes d'actionneur (24) servent en même temps d'électrodes de capteur (34) du dispositif capteur (38) du dispositif régulateur local (30).

6. Composant optique (25) selon la la revendication 5, **caractérisé en ce que** l'au moins une électrode de capteur (34) est reliée à un redresseur pour permettre la transmission de signaux.

7. Composant optique (25) selon la revendication 6, **caractérisé en ce que** tous les éléments de miroir (23) comprennent dans chaque cas une électrode de miroir (22 ; 37) qui est maintenue de manière isopotentielle par rapport aux électrodes de miroir (22 ; 37) des autres éléments de miroir (23).

8. Unité d'éclairage optique (4), comprenant une premier miroir à facettes (13) possédant au moins un composant optique (25) selon l'une quelconque des revendications 1 à 7.

9. Système d'éclairage (2), comprenant
a. une unité d'éclairage optique (4) selon la revendication 8, et
b. une source de rayonnement (3).

10. Appareil d'exposition par projection (1) pour microlithographie, comprenant
a. une unité d'éclairage optique (4) selon la revendication 9, et
b. une unité de projection optique (7).

11. Procédé de régulation de l'inclinaison d'un élément de miroir (23) d'un composant optique (25) tel que défini par la revendication 1, le composant optique (25) étant un miroir à facettes (13, 14), comprenant les étapes suivantes :
a. fourniture d'un miroir à facettes (13, 14) pourvu d'une pluralité d'éléments de miroir (23), les éléments de miroir individuels (23) étant inclinables par un système actionneur et possédant au moins une électrode de miroir (22 ; 37) faisant partie d'un capteur capacitif,
b. fourniture d'au moins un dispositif actionneur possédant au moins deux électrodes d'actionneur (24) pour chaque degré de liberté d'inclinaison, destinées à incliner l'élément de miroir (23), agencées dans chaque cas symétriquement par rapport à un axe d'inclinaison,
c. fourniture d'un générateur de signaux (39) destiné à générer un signal de modulation possédant une fréquence au-dessus d'une fréquence de résonance de l'élément de miroir (23), le générateur de signaux (39) étant relié aux électrodes d'actionneur (24) pour permettre la transmission de signaux,
d. application d'une tension comprenant au moins une partie modulation (V_{Mod}) aux au moins deux électrodes d'actionneur (24), la partie modulation (V_{Mod}) étant appliquée en parallèle à deux électrodes d'actionneur (24),
e. détection d'un signal de capteur au moyen du capteur capacitif, et
f. détermination d'un signal de rétroaction pour la régulation de l'inclinaison de l'élément de miroir (23) à partir de l'amplitude et/ou de la phase du signal de capteur.

12. Procédé selon la revendication 11, **caractérisé en ce que** la partie modulation (V_{Mod}) possède une fréquence limite supérieure qui se situe au moins une décade au-dessus d'une fréquence de résonance (fᵣₑₛ) de l'élément de miroir (23).

13. Procédé selon l'une ou l'autre des revendications 11 et 12, **caractérisé en ce qu'**au moins une partie actionneur (V_{Act}) et la partie modulation (V_{Mod}) sont appliquées aux au moins deux électrodes d'actionneur (24) .

14. Procédé de fabrication d'un composant micro- ou nanostructuré, comprenant les étapes suivantes :
- fourniture d'un substrat, sur lequel est au moins partiellement appliquée une couche composée d'un matériau photosensible,
- fourniture d'un réticule possédant des structures à imager,
- fourniture d'un appareil d'exposition par projection (1) selon la revendication 10,
- projection d'au moins une partie du réticule sur une région de la couche photosensible du substrat à l'aide de l'appareil d'exposition par projection (1).
